# EUROPEAN PATENT SPECIFICATION

(11) **EP 0 382 948 B1**
(45) Date of publication and mention of the grant of the patent: **08.10.2003**
(21) Application number: 89200352.6
(22) Date of filing: 14.02.1989
(51) Int. Cl.: H01L 23/50

(54) **Supply pin rearrangement for an integrated circuit**
Versorgungssteckerstift-Anordnung für eine integrierte Schaltung
Assemblage de bornes d'alimentation pour un circuit intégré

(43) Date of publication of application: 22.08.1990
(60) Divisional application: 01202742.1
(73) Proprietor: Koninklijke Philips Electronics N.V., 5621 BA Eindhoven (NL)
(72) Inventor: Salters, Roelof Herman Willem, NL-5656 AA Eindhoven (NL); Prince, Betty, 77479 Sugarland, Texas (US)
(74) Representative: Duijvestijn, Adrianus Johannes

(56) References cited:
- EP-A- 0 074 825
- EP-A- 0 151 870
- EP-A- 0 205 728
- COMPUTER DESIGN, vol. 25, no. 21, 15th November 1986, pages 28,30,32, Littleton, MA, US; J. BOND: "TI's pinout scheme for ACL devices still under attack"
- PATENT ABSTRACTS OF JAPAN, vol. 8, no. 272 (E-284)[1709], 13th December 1984; & JP-A-59 144 155 (NIPPON DENKI K.K.) 18-08-1984
- PATENT ABSTRACTS OF JAPAN, vol. 10, no. 325 (E-451)[2381], 6th November 1986; & JP-A-61 133 651 (NEC CORP.) 20-06-1986
- PATENT ABSTRACTS OF JAPAN, vol. 11, no. 27 (E-474)[2474], 27th January 1987; & JP-A-61 196 562 (HITACHI LTD) 30-08-1986

## Description

The invention relates to an integrated circuit being coupled to connection pins via conductive connections, among which connection pins there is at least one first supply pin for connection to a first supply voltage and at least one second supply pin for connection to a second supply voltage. Integrated circuits of this kind are widely known, for example in an encapsulated form, the connection pins extending beyond the encapsulation.

According to the current art in I.C.-technology, it is possible to realize on a substrate structures having minimum dimensions in the order of magnitude of a tenth of a micron. However, the ever progressing miniaturization entails an increasing susceptibility of circuits to electrical parasitic effects. An example of such effects are the inductive voltage fluctuations on the chip's internal supply lines caused by the circuit's activity on the one hand and the bonding wires' and supply pins' inductances on the other hand. A major factor limiting the switching speed of digital circuitry is the occurrence of these inductive voltage fluctuations, which may have a detrimental effect on the I.C.

The encapsulation of I.C.'s, e.g. microprocessors or memories, wherein the supply pins are located diametrically opposite to one another, is a widely accepted standard. Reference is made to Philips Data Handbook IC10, 1987, page 103, showing the pinning diagram for a SRAM, and to Philips Data Handbook IC14, 1987, page 322, showing the pinning diagram for a microcontroller. However, as the miniaturization goes on and the maximum of the clock frequency tends to increase, the drawbacks of this standard become more apparent. For instance, a smoothing capacitance, according to common practice located between the first supply pin and the second supply pin, necessarily needs long wires to cover the distance between the supply pins located diametrically. The parasitic impedance of these wires diminishes the efficiency of the smoothing capacitance. Also, such long wires are liable to act as antennae for receiving or transmitting disturbances interfering with the circuitry.

Furthermore, an inductive loop comprising the chip, whereon the bonding pads for the bonding wires connected to the supply pins are located, the bonding wires and the supply pins themselves, has a considerable inductance because of its relatively large area. This causes the occurrence of inductive'voltage spikes on the chip's internal supply lines, which spikes may interfere with the operation of the integrated circuit. Moreover, the series arrangement of a supply pin and an associated bonding wire has an electrical path length that is the longest possible in the conventional dual-in-line I.C. This causes the impedance thereof, in particular the inductance, to be the largest possible.

Conventional pin arrangement other than that of the dual-in-line arrangement entail similar drawbacks. For example, in the pinning arrangement of the microcontroller, shown in Philips Data Handbook IC14, 1987, page 34, the connection pins are located along the circumference of the I.C. Two supply pins are provided at opposite sides of the I.C. Consequently, a smoothing capacitor connected between the supply pins creates a relatively large loop likewise. Other arrangements of connection pins may comprise connection pins arranged in a grid having more than two columns and more than two rows. Such a grid arrangement allows a large density of pins, which in particular is advantageous for I.C.'s that consume more power. Especially in high power-consumption environment, where currents and current changes are large, the operation may be limited by the above inductive effect.

Therefore, it is an object of the invention to provide an integrated circuit module as described in the introductory part of claim 1, and an integrated circuit chip according to the introductory part of claim 7 being less susceptible to said parasitic effects. To this end an integrated circuit module according to the invention is characterized, by the characterizing part of claim 1. To this end an integrated circuit chip is characterized by the characterizing part of claim 7. The inductance of the series arrangement of a supply pin and its associated conductive connection now is the lowest possible.

It is noted that EP 205728 A2 descibes an integrated circuit chip suitable for connection, two kinds of power supplies that are to used for operating the integrated circuit chip, and a ground which constitutes a source power supply which is common to the two power supplies are connected to the Input-output pins that are provided on the package for the chip. Here, the input-output pins connected to the power supplies are adjacently arranged on both sides of the input-output pin that is connected to the ground. Consequently, the lengths of the power supply current loops that are formed between the power supply terminals and the ground terminal are designed to become short, and hence the high frequency radiation from the loops reduced accordingly.

This document however, does not disclose the location of output pins.

By locating the first and second supply pins next to one another, the area of the loop described herein above is further decreased considerably, thus minimizing the inductances. Another advantage of this supply pin arrangement is, that the associated bonding wires and supply pins conduct currents in an anti-parallel orientation. This causes the common effective inductance of this arrangement of supply pins and associated bonding wires to be less than half of the inductance of a single bonding wire due to a substantial cancellation electro-magnetic fields generated by the inductances of the neighbouring wires.

An embodiment of an integrated circuit according to the invention is characterized, in that there are provided at least two first supply pins and at least two second supply pins.This architecture decreases the amplitude of disturbances at the chip's internal supply lines even more because the presence of at least two supply pins and wires per supply voltage reduces the current per supply path by at least a factor 2.

Embedded in a data processing system a plurality of other circuitry may be interconnected to the output pins. Each of the other circuits and the interconnections thereto represent impedances. Therefore output pins for transmitting output signals to other circuitry usually carry more powerful signals than other pins. By arranging the output pins in the immediate proximity of said supply pins the distance between the chip and the output pins is only slightly greater than the distance between the chip and the supply pins. As a consequence the inductance of the relevant wires and the output pins is only slightly larger in magnitude. Moreover, the effects of large currents and rapid current changes have only small effect on the supply voltages at the supply pins, for the latter are well protected by their pairwise presence. An even more important advantage of the arrangement of the output pins in the immediate neighbourhood of the supply pins is that now the output buffers for transmitting the output signals at the output pins are fed via short supply lines. This causes the amplitude of inductive voltage spikes due to large current changes during the buffer's operation to be smaller than the amplitude of spikes occurring in a conventional integrated circuit in similar circumstances.

It is noted that the article "Ti's pinout scheme for ACL devices still under attack", by John Bond, Computer Design, Nov, 15, 1986, pp. 28-32 describes a pinout arrangement, where the output pins are located an both sides of centrally located supply pins. However, in this arrangement the adjacent supply pins serve for supplying the same supply voltage and are therefore not shielded against pick-up of induction from neighbouring output pins.

A still further embodiment of an integrated circuit wherein the connection pins further comprise control pins such as a clock-input, or a chip-enable, or a read-enable or a write-enable, or an output-enable or a program-enable, according to the invention, is characterized in that the control pins are located nearer to a predetermined supply pin than connection pins not being a supply pin or output pin. By locating control pins, such as clock pins and enable pins in the immediate proximity of the paired supply pins a core of pins has been created. The pins forming said core are present in almost all I.C.'s. Chip designers may therefore take such a core as a starting point for creating a circuit, which is less sensitive to inductive interferences and generates much less of such inductive voltage spikes. Extensions of circuits designed according to the invention are easily accomplished, for the locations of the bulk of the pins and therefore the main parts of the lay-out are predetermined. For memories in particular this way of designing has important advantages as the memory cell matrices differ only in size, but not in lay-out.

According to the experiments conducted on a memory according to the invention, the amplitudes of disturbing voltages caused by switching were lower by a factor 4 à 5 than in a memory conventionally supplied.

The invention will be illustrated by way of example with reference to a drawing, in which
Figure 1 presents the pin arrangement of a conventional dual-in-line I.C.;
Figure 2 presents the pin arrangement in accordance with the invention of a dual-in-line I.C.;
Figure 3 shows the pin arrangement of a conventional I.C. having pins disposed circumferentially, and
Figure 4 shows the pin arrangement of an I.C. having pins disposed circumferentially in accordance with the invention.

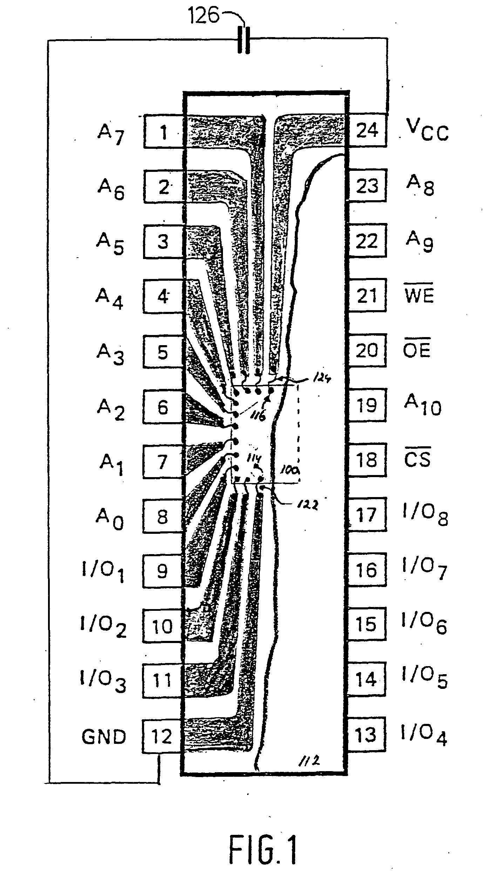

In Figure 1 an example of the pin arrangement of a conventional dual-in-line I.C. is shown. The Figure shows a SRAM I.C., comprising an integrated circuit chip 100 encapsulated within an encapsulation 112, that has been drawn partially for the sake of clarity. The chip 100 is provided with bonding pads such as 114 and 116, located near the edges of chip 100. The bonding pads shown are connected via conductive connections, e.g. bonding wires, such as 122 and 124, to the connection pins 1-24 extending beyond the encapsulation 112. The connection pins 1-24 and the bonding wires such as 122 and 124 couple the chip 100 to the external world. The chip 100 is supplied with a supply voltage V_{CC} via supply pin 24 and bonding wire 124, and with a supply voltage GND via supply pin 12 and bonding wire 122. In accordance with the widely accepted standard, supply pins 12 and 24 are placed diametrically opposite to each other. Connection pins 9-11 and 13-17 are input/output pins for data transport. Connection pins 1-8, 19, 22 and 23 are address pins. Connections 18, 20, and 21 serve as control pins for controlling the chip 100 with a chip-select signal, an output-enable signal and a write-enable signal, respectively.

As can be seen in the drawing the locations of the bonding pads, among which are pads 114 and 116, correspond circumferentially with the locations of the connection pins 1-24. As a consequence of this set up the electrical path length of the supply arrangement, comprising supply pin 12 and bonding wire 122, and supply pin 24 and bonding wire 124, is the longest possible among all series connections of a connection pin and its associated bonding wire present.

Another consequence is that, because of the supply pins 12 and 24 being disposed diametrically opposite to each other, the distance between said pins 12 and 24 is the longest possible between any pair of connection pins.

This architecture has several drawbacks. First since the electrical path length of the series arrangement of supply pin 12 and bonding wire 122 and the electrical path length of the series arrangement of supply pin 24 and bonding wire 124 are the longest present, the inductance of each of said series arrangements is the largest present. In the operating mode of the I.C., large and rapidly varying currents are conducted by said supply pins 12 and 24 and the associated bonding wires 122 and 124. Therefore, since both the current changes and the inductances are large, inductive voltage spikes are liable to occur on the supply pins 12 and 24 and the associated bonding wires 122 and 124. The spikes then are propagated onto the internal supply lines of the chip. Because of the large electrical path lengths mentioned hereinbefore, the voltage spikes generated on the supply pin and the bonding wire may be in the same order of magnitude as voltage spikes generated on the chip's internal supply lines (not shown).

In order to reduce the amplitude of the voltage spikes and the interference of said voltage spikes with other information carrying signals a smoothing capacitor 126 is connected between the supply pins 12 and 24. Another drawback of the conventional architecture emanates from the connection of this capacitor 26. As the supply pins 12 and 24 are located diametrically opposite to each other the smoothing capacitor 26 has to be connected there-between by means of relatively long wires. This implies a presence of a loop of conductors, comprising the capacitor's 26 wires, the supply pins 12 and 24 and the bonding wires 122 and 124, the relatively large area thereof allowing further inductive effects, interfering the operation of the I.C. or with other circuitry in the I.C.'s neighbourhood (not shown). Also, the long wires' impedance may cause delays, thereby reducing the capacitor's 26 effect.

As the miniaturization of the I.C.'s proceeds and the maximum clock frequency possible tends to increase further, the inherent drawbacks of the conventional pinning system become even more apparent. As a consequence of ever decreasing scales and ever increasing clock frequencies the inductive voltage spikes are more liable to have detrimentally effects on the chip itself, e.g. they may give rise to the breakdown of transistors. Therefore, unless the current changes on the supply are adapted to the limitations of the conventionally pinned I.C., which implies among other things a relatively low maximum clock frequency and as a consequence a low operation speed, a safe operation of the I.C. is not possible anymore.

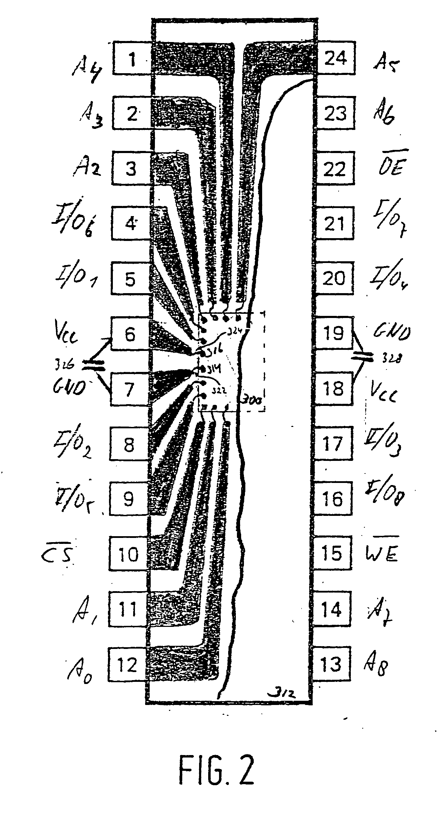

In Figure 2 the pin arrangement of an I.C. according to the invention is presented by way of an example. The Figure shows a SRAM I.C., comprising an integrated circuit chip 300 encapsulated within an encapsulation 312, that has been drawn only partially for clarity. The chip 300 is provided with bonding pads, such as 314 and 316, that are located near the edges of chip 300. The bonding pads are connected via bonding wires, such as 322 and 324, to the connection pins 1-24, extending beyond the encapsulation 312. The chip 300 is supplied with a supply voltage V_{CC} via supply pins 6 and 18, and with a supply voltage GND via supply pins 7 and 19. In contrast to the pin arrangement shown in the previous Figure, the supply pins 6 and 7 (and 18 and 19) now are disposed in such a manner as to minimize the respective aggregated electrial path length of the respective supply pin and its associated bonding wire. To this end, the supply pins 6 and 7 on the one hand and the supply pins 18 and 19 on the other hand are located centrally within their associated sequencies of connection pins. By minimizing said electrical path length, the aggregated inductance of the series arrangement of a supply pin and its associated bonding wire is reduced considerably with respect to the aggregated inductance present in the corresponding supply pin and bonding wire of the conventionally pinned I.C. of the previous Figure.

By locating the supply pins for V_{CC} and GND next to each other, like pins 6 and 7 (and pins 18 and 19), a smoothing capacitor 326 (328) can be connected there-between using very short connecting wires. The loop, formed by the two supply pins 6 and 7, the bonding wires 322 and 324, chip 300 and capacitor 326 now has an extremely short circumference and an extremely small area enclosed thereby. The wires now connecting capacitor 326 (328) to the supply pins have a much smaller impedance than in the case shown in Figure 1, which increases the capacitor's effect. Moreover, the area of said loop is much smaller than in the case of the previous Figure, which implies a much smaller loop-inductance, and therefore a much lower susceptibility to e.g. externally generated electromagnetic fields. If space will permit the smoothing capacitor 326 (e.g. a surface mounted device) may be connected between the relevant supply pins inside of the encapsulation 312 or may be integrated within the supply pins themselves.

Another advantage of the supply pin arrangement having a V_{CC}-pin in the immediate proximity of a GND-pin is the reduction of the effective aggregated inductances of the supply pins and the associated bonding wires. This reduction is caused by the anti-parallel orientation of the currents conducted in the conductors each comprising a supply pin and an associated bonding wire. The mutual inductance generated by anti-parallel oriented currents in two conductors disposed parallel to each other causes the effective inductance of the parallel arranged conductors to be less than half of the inductance of a single conductor.

The shown I.C. further is provided with two supply pins 6 and 18 for supply voltage V_{CC} and two supply pins 7 and 19 for supply voltage GND. The current conducted per supply pin now is halved with respect to the case shown in Figure 1, which further reduces the amplitude of inductive voltage spikes.

The locations of the V_{CC} pins 6 and 18 and of the GND pins 7 and 19 are chosen to be rotationally symmetrical as can be seen from the drawing. A mirror-symmetrical arrangement of the supply pins could lead to the destruction of the I.C. in case it would unintentionally be inserted into a circuit board the other way around, that is in the drawing upside down.

As can be seen from Figure 2 output pins 5, 8, 17 and 20 are located next to a supply pin. Said output pins are externally accessible terminals, coupled to outputs of the on-chip output buffers (not shown). The arrangement of output pins next to supply pins has several advantages. First, the length of the electrical path constituted by an output pin and its associated bonding wire is in the same order of magnitude as, or equal to, the length of the electrical path constituted by a supply pin and its associated bonding wire. Consequently, the impedance (inductance) of the former is equally low. Second, the output buffers are located in the margin of chip 300. Because of the buffers' locations near the bonding pads for connection to the supply terminals and for connection to the output pins, the buffers are supplied via short on-chip supply lines (not shown). Short supply lines are advantageous for output buffers in particular, since they generally switch large current that may cause inductive voltage spikes on the associated supply lines. If the supply lines are kept as short as possible, the inductance thereof will be equally low.

The control pin 10 for the chip-select signal, the control pin 15 for the write-enable signal and the control pin 22 for the output-enable are disposed beyond the output pins in their associated sequences of connection pins. The set of supply pins 6, 7, 18, 19, the output pins 4, 5, 8, 9, 16, 17, 20, 21 and the control pins 10, 15, 22 forms a core of frequently occurring pins in a memory I.C. For another type of I.C., for instance a microcontroller, another set of control pins may be arranged as the specific application of the I.C. may require. The concentration of said supply pins, output pins and control pins into a core, and dividing the chip into core circuitry and additional circuitry, has several advantages. First, the I.C. is less sensitive to inductive voltage spikes as already has been discussed herein above. Second, the core of standard connection pins offers a starting point for I.C.-designers that is common to various lay-outs and from whereon extensions are relatively easy to make.

In the Figure 2 the address pins 1, 2, 3, 11, 12, 13, 14, 23, 24 are located beyond the control pins and the output pins. For memory designers in particular this dividing in core-circuitry and additional circuitry has the advantage that memories with various capacities may use identical cores, less sensitive to the above mentioned inductive interferences.

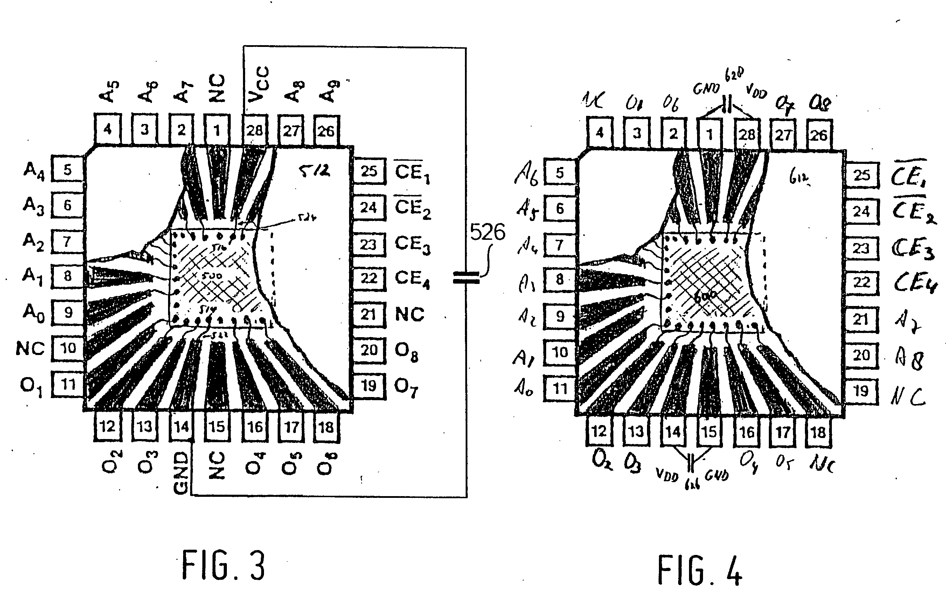

In Figure 3 an example is shown of the pin arrangement for a conventional memory I.C. having connection pins located along its circumference. The I.C. comprises an integrated circuit chip 500 encapsulated within encapsulation 512, which has been drawn only partially for clarity. The chip 500 is provided with bonding pads such as 514 and 516, located near the chip's 500 edges. The bonding pads are connected to the connection pins, such as 14 and 28 via bonding wires, such as 522 and 524. Connection pins 28 and 14 are supply pins for receiving supply voltages V_{CC} and GND, respectively. Connection pins 1, 10, 15 and 21 are not connected. Connection pins 11-13 and 16-20 are output pins, connections 2-9, 26 and 27 are address pins and connection pins 22-24 are control pins for receiving various chip-enable signals, which are included for the ease of memory expansion.

As can be seen, the supply pins 14 and 28 have not the best possible location in view of the reduction of inductive interferences. First, they are not the shortest possible connection pins, for pins 1 and 15 are shorther but are not connected. Second, the supply pins are located on opposite sides of the I.C. Smoothing capacitor 526 is to be connected between the supply pins 28 and 14 using wires that bridge the long distance across the I.C. What has been further described with reference to the I.C. of Figure 1 with regard to the drawbacks of the pin arrangement will apply equally to the I.C. of Figure 3.

In Figure 4 an example of the pin arrangement for an I.C. having its pins disposed circumferentially is shown. The Figure shows an integrated circuit chip 600 within an encapsulation 612. The V_{DD} supply pins 14 and 28 now are located next to a GND supply pin 15 and 1, respectively. Furthermore, the arrangement of a V_{DD} supply pin next to a GND supply pin is located centrally in a relevant sequence of connection pins, that is, the arrangement is flanked by other connection pins on both sides, the number of other connection pins being approximately equal for both sides. Smoothing capacitors 626 and 628 have been connected between supply pins 14 and 15 and supply pins 1 and 28, respectively, via short wires. The output pins 12, 13 and 16, 17 are disposed next to the arrangement of supply pins 14 and 15. The output pins 3, 2 and 27, 26 are disposed next to the arrangement of supply pins 1 and 28. The connection pins 22-25 constitute the control pins for various chip-enable signals, the connection pins 5-11, 20 and 22 constitute the address pins.

Although the above examples refer to memories, similar pin-arrangements could be made for other kind of circuits, e.g. microcontrollers. Likewise, similar arrangements are possible for integrated circuit modules comprising more than a single chip, which pin-arrangements similarly reflect the object of the invention to reduce the inductive voltage spikes by pairing the supply pins in the nearest proximity of the chips, and by disposing output pins next to the supply pins in the respective connection pin-arrangements.

## Claims

1. An integrated circuit module comprising
- an integrated circuit chip (300) comprising a memory matrix;
- a plurality of external connection pins (1, 2, ..., 24), comprising at least a first supply voltage pin for connection to a first supply voltage (Vcc) and a second supply voltage pin (7) for connection to a second supply voltage (GND) different from the first supply voltage (Vcc), the first supply pin and the second supply pin being located adjacent one another;
- a plurality of conductive connections (322, 324, ...) coupling the integrated circuit chip (300) to the external connection pins (1, 2, ..., 24), an aggregate electrical path length of each of said supply pins and the respective conductive connection between the integrated circuit chip and the supply pin being equal to or shorter than an aggregate electrical path length of any of the connection pins, not being a supply pin, and the respective conductive connection between the circuit and the relevant connection pin not being a supply pin;
**characterized in that** the external connection pins comprise output pins (5,8), and the integrated circuit chip (300) comprises respective output buffers connected to output pins for supplying respective output signals, a respective one of the output pins being located next to each of the first and second supply pins.

2. The integrated circuit module of claim 1, wherein the connection pins comprise a third supply pin (18) for connection to the first supply voltage (Vcc) and a fourth supply pin (19) for connection to the second supply voltage (GND), the third and fourth supply pins (18,19) being located. adjacent one another, the first and second supply pins being located at one side of the integrated circuit and the third and fourth supply pins being located at an opposite side of the integrated circuit, respective ones the output pins (17,20) being located next to each of the third and fourth supply pins (18,19).

3. An integrated circuit module according to Claim 1, wherein the external connection pins are arranged in at least a sequence of connection pins, the first and second supply pins being located next to each other and substantially centrally in the sequence; the integrated circuit chip (300) having a series of bonding pads (314, 316) located adjacent to the sequence of connection pins, each respective one of the connection pins being connected to a respective one of the bonding pads via a respective one of the bonding wires (322, 324); the bonding pads comprising a first and second supply pad connected to the first and second supply pin respectively, the first and second supply pads being located next to each other centrally in the series; a first and a second output pad being located next to the first and second supply pad respectively, the first and second output pad being connected to the output pins located next to the first and second supply pins respectively.

4. An integrated circuit module according to claim 3, the external connection pins being arranged in at least the sequence of connection pins and a further sequence of connection pins, the integrated circuit chip being located between said sequence and said further sequence; the connection pins comprising a third and fourth supply pin (18,19) located next each other centrally in said further sequence, the third and fourth supply pin (18,19) being for connection to the first and second supply voltages, respectively; the integrated circuit chip (300) having a further series of bonding pads located adjacent to the further sequence of connection pins, the further series of bonding pads comprising is a third and fourth supply pad connected to the third and fourth supply pin respectively, the third and fourth supply pad being located next to one another in the further series; a third and fourth output pad being located next to the third and fourth supply pad respectively, the third and fourth output pad being connected to output pins located next to the third and fourth supply pins respectively.

5. An integrated circuit module according to claim 1, 2, 3 or 4 wherein the connection pins further comprise control pins (10, 15, 22), such as a clock-input, or a chip-enable, or a write-enable, or a read-enable, or an output-enable, or a program-enable; the external connection pins being arranged in at least a sequence, the sequence comprising the first and second supply pins, at least some of the output pins and the control pins, no control pin being located in the sequence between any of the output pins and the supply pins.

6. An integrated circuit module according to claim 5, the sequence comprising a core of connection pins, comprising all of the control pins, output pins and supply pins, the sequence comprising address pins, each located in the sequence outside said core.

7. An integrated circuit chip comprising a memory matrix having a series of bonding pads for connection to connection pins, wherein the bonding pads comprise a first supply pad (316) for receiving a first supply voltage (Vcc), a second supply pad (314) for receiving a second supply voltage (GND) different from the first supply voltage; the first and second supply pads being located next to each other in the series; **characterized in that** the series of bonding pads contains output pads, the integrated circuit chip comprising output buffers coupled to respective ones of the output pads for supplying output signals, a respective one of the output pads being located in the series next to each of the first and second supply pads.

8. An integrated circuit chip according to claim 7, comprising a further series of bonding pads, the series and the further series being located at opposite sides of the substrate, the further series of bonding pads comprising a third and fourth supply pad located next to each other, for receiving the first and second supply voltage respectively, the series of bonding pads containing further output pads, the integrated circuit chip comprising further output buffers coupled to respective ones of the further output pads, respective ones of the further output pads being located in the further series next to each of the third and fourth supply pads.

9. An integrated circuit chip according to claim 7or 8, wherein the bonding padsfurther comprise control pads, such as a clock-input, or a chip-enable, or a write-enable, or a read-enable, or an output-enable, or a program-enable; the control pads being located in the series of control pads, no control pad being located in the series between any of the output pads and the supply pads. or

10. An integrated circuit chip according to claim 7, 8 or 9, the series comprising a core of connection pads, comprising a1l of the control pads, output pads and supply pads, the series comprising address pads, each located in the series outside said core.

## Patentansprüche

1. Modul einer integrierten Schaltung mit
- einem integrierten Schaltungschip (300) mit einer Speichermatrix;
- einer Vielzahl externer Anschlussstifte (1, 2,..., 24), mit zumindest einem ersten Speisespannungsanschlussstift zum Anschluss an eine erste Speisespannung (V_{CC}) und einem zweiten Speisespannungsanschlussstift (7) zum Anschluss an eine zweite Speisespannung (GND), die sich von der ersten Speisespannung (V_{CC}) unterscheidet, wobei der erste Speiseanschlussstift und der zweite Speiseanschlussstift benachbart zueinander liegen;
- einer Vielzahl leitfähiger Verbindungen (322, 324,...), die den integrierten Schaltungschip (300) mit den externen Anschlussstiften (1, 2, ..., 24) koppeln, wobei eine gesamte elektrische Weglänge jedes der genannten Speiseanschlussstifte und der jeweiligen leitfähigen Verbindung zwischen dem integrierten Schaltungschip und dem Speiseanschlussstift gleich oder kürzer ist als eine gesamte elektrische Weglänge eines beliebigen der Anschlussstifte, der kein Speiseanschlussstift ist, und der jeweiligen leitfähigen Verbindung zwischen der Schaltung und dem betreffenden Anschlussstift, der kein Speiseanschlussstift ist;
**dadurch gekennzeichnet, dass** die externen Anschlussstifte Ausgangsanschlussstifte (5,8) umfassen und der integrierte Schaltungschip (300) jeweilige Ausgangspuffer umfasst, die mit Ausgangsanschlussstiften zum Abgeben jeweiliger Ausgangssignale verbunden sind, wobei ein jeweiliger der Ausgangsanschlussstifte neben jedem der ersten und der zweiten Speiseanschlussstifte liegt.

2. Modul einer integrierten Schaltung nach Anspruch 1, in dem die Anschlussstifte einen dritten Speiseanschlussstift (18) zum Anschluss an die erste Speisespannung (V_{CC}) und einen vierten Speiseanschlussstift (19) zum Anschluss an die zweite Speisespannung (GND) umfassen, wobei die dritten und vierten Speiseanschlussstifte (18,19) benachbart zueinander liegen, wobei die ersten und der zweiten Speiseanschlussstifte an einer Seite der integrierten Schaltung und die dritten und vierten Speiseanschlussstifte an der entgegengesetzten Seite der integrierten Schaltung liegen, wobei jeweilige der Ausgangsanschlussstifte (17,20) neben jedem der dritten und vierten Speiseanschlussstifte (18,19) liegen.

3. Modul einer integrierten Schaltung nach Anspruch 1, in dem die externen Anschlussstifte in zumindest einer Abfolge von Anschlussstiften angeordnet sind, wobei die ersten und zweiten Speiseanschlussstifte nebeneinander liegen und nahezu zentral in der Abfolge; wobei der integrierte Schaltungschip (300) eine Reihe von Bondflecken (314, 316) hat, die benachbart zu der Abfolge von Anschlussstiften liegt, wobei jeder jeweilige der Anschlussstifte mit einem jeweiligen der Bondflecken über einen jeweiligen der Bonddrähte (322, 324) verbunden ist; wobei die Bondflecken einen ersten und zweiten mit dem ersten bzw. zweiten Speiseanschlussstift verbundenen Speisebondfleck umfassen, wobei die ersten und zweiten Speisebondflecken nebeneinander zentral in der Reihe liegen; wobei ein erster und ein zweiter Ausgangsbondfleck neben dem ersten bzw. zweiten Speisebondfleck liegen, wobei der erste und zweite Ausgangsbondfleck mit den neben den ersten bzw. zweiten Speiseanschlussstiften liegenden Ausgangsanschlussstiften verbunden sind.

4. Modul einer integrierten Schaltung nach Anspruch 3, wobei die externen Anschlussstifte in zumindest der Abfolge von Anschlussstiften und einer weiteren Abfolge von Anschlussstiften angeordnet ist, wobei der integrierte Schaltungschip zwischen der genannten Abfolge und der genanten weiteren Abfolge liegt; wobei die Anschlussstifte einen dritten und vierten Speiseanschlussstift (18,19) umfassen, die nebeneinander zentral in der genannten weiteren Abfolge liegen, wobei der dritte und vierte Speiseanschlussstift (18,19) zum Anschluss an die ersten bzw. zweiten Speisespannungen dienen, wobei der integrierte Schaltungschip (300) eine weitere Reihe von Bondflecken hat, die neben der weiteren Abfolge von Anschlussstiften liegen, wobei die weitere Reihe von Bondflecken einen dritten und vierten Speisebondfleck umfasst, die mit dem dritten bzw. vierten Speiseanschlussstift verbunden sind, wobei der dritte und vierte Speisebondfleck nebeneinander in der weiteren Reihe liegen; wobei ein dritter und vierter Ausgangsbondfleck neben dem dritten bzw. vierten Speisebondfleck liegt, wobei der dritte und vierte Ausgangsbondfleck mit Ausgangsanschlussstiften verbunden sind, die neben den dritten bzw. vierten Speiseanschlussstiften liegen.

5. Modul einer integrierten Schaltung nach Anspruch 1, 2, 3 oder 4, wobei die Anschlussstifte weiterhin Steueranschlussstifte (10, 15, 22) umfassen, wie z.B. einen Takteingang oder eine Chip-Freigabe oder eine Schreib-Freigabe oder eine Lese-Freigabe oder eine Ausgabe-Freigabe oder eine Programm-Freigabe; wobei die externen Anschlussstifte in zumindest einer Abfolge angeordnet sind, wobei die Abfolge die ersten und zweiten Speiseanschlussstifte, zumindest einige der Ausgangsanschlussstifte und die Steueranschlussstifte umfasst, wobei kein Steueranschlussstift in der Abfolge zwischen irgendeinem der Ausgangsanschlussstifte und den Speiseanschlussstiften liegt.

6. Modul einer integrierten Schaltung nach Anspruch 5, wobei die Abfolge einen Kern von Anschlussstiften umfasst, der alle Steueranschlussstifte, Ausgangsanschlussstifte und Speiseanschlussstifte umfasst, wobei die Abfolge Adressanschlussstifte umfasst, die jeder in der Abfolge außerhalb des genannten Kerns liegen.

7. Integrierter Schaltungschip mit einer Speichermatrix, der eine Reihe von Bondflecken zum Anschluss an Anschlussstifte hat, wobei die Bondflecken einen ersten Speisebondfleck (316) zum Empfangen einer ersten Speisespannung (V_{CC}) umfassen sowie einen zweiten Speisebondfleck (314) zum Empfangen einer zweiten Speisespannung (GND), die sich von der ersten Speisespannung unterscheidet; wobei die ersten und zweiten Speisebondflecken in der Reihe nebeneinander liegen; **dadurch gekennzeichnet, dass** die Reihe von Bondflecken Ausgangsbondflecken enthält, wobei der integrierte Schaltungschip mit jeweiligen der Ausgangsbondflecken gekoppelte Ausgangspuffer umfasst zum Abgeben von Ausgangssignalen, wobei ein jeweiliger der Ausgangsbondflecken in der Reihe neben jedem der ersten und zweiten Speisebondflecken liegt.

8. Integrierter Schaltungschip nach Anspruch 7, mit einer weiteren Reihe von Bondflecken, wobei die Reihe und die weitere Reihe an entgegengesetzten Seiten des Substrats liegen, wobei die weitere Reihe von Bondflecken einen dritten und vierten Speisebondfleck umfasst, die nebeneinander liegen, zum Empfangen der ersten bzw. zweiten Speisespannung, wobei die Reihe von Bondflecken weitere Ausgangsbondflecken enthält, wobei der integrierte Schaltungschip weitere Ausgangspuffer umfasst, die mit jeweiligen der weiteren Ausgangsbondflecken gekoppelt sind, wobei jeweilige der weiteren Ausgangsbondflecken in der weiteren Reihe neben jedem der dritten und vierten Speisebondflecken liegen.

9. Integrierter Schaltungschip nach Anspruch 7 oder 8, in dem die Bondflecken weiterhin Steuerbondflecken umfassen, wie z.B. einen Takteingang oder eine Chip-Freigabe oder eine Schreib-Freigabe oder eine Lese-Freigabe oder eine Ausgabe-Freigabe oder eine Programm-Freigabe; wobei die Steuerbondflecken in der Reihe von Steuerbondflecken liegen, wobei kein Steuerbondfleck in der Reihe zwischen irgendeinem der Ausgangsbondflecken und der Speisebondflecken liegt.

10. Integrierter Schaltungschip nach Anspruch 7, 8 oder 9, wobei die Reihe einen Kern mit Anschlussbondflecken umfasst, der alle Steuerbondflecken, Ausgangsbondflecken und Speisebondflecken umfasst, wobei die Reihe Adressbondflecken umfasst, die je in der Reihe außerhalb des genannten Kerns liegen.

## Revendications

1. Module de circuit intégré comportant
- une puce de circuit intégré (300) comportant une matrice de mémoire;
- une pluralité de broches de connexion externes (1,2, ..., 24) comportant au moins une première broche de tension d'alimentation pour être connectée à une première tension d'alimentation (Vcc) et une deuxième broche de tension d'alimentation (7) pour être connectée à une deuxième tension d'alimentation (GND) qui est différente de la première tension d'alimentation (Vcc), la première broche d'alimentation et la deuxième broche d'alimentation l'une étant située d'une manière contiguë à l'autre;
- une pluralité de connexions conductrices (322, 324,...) couplant la puce de circuit intégré (300) aux broches de connexion externes (1,2,..., 24), une longueur de trajectoire électrique collective de chacune desdites broches d'alimentation et de la connexion conductrice respective entre la puce de circuit intégré et la broche d'alimentation étant égale ou inférieure à une longueur de trajectoire électrique collective de l'une quelconque des broches de connexion, celle-ci n'étant pas une broche d'alimentation, et la connexion conductrice respective entre le circuit et la broche de connexion concernée n'étant pas une broche d'alimentation;
**caractérisé en ce que** les broches de connexion externes comportent des broches de sortie (5, 8) et **en ce que** la puce de circuit intégré (300) comporte des tampons de sortie respectifs qui sont connectés à des broches de sortie pour transmettre des signaux de sortie respectifs, une broche de sortie respective des broches de sortie étant située à côté de chacune des première et deuxième broches d'alimentation.

2. Module de circuit intégré selon la revendication 1, dans lequel les broches de connexion comportent une troisième broche d'alimentation (18) pour être connectée à une première tension d'alimentation (Vcc) et une quatrième broche d'alimentation (19) pour être connectée à une deuxième tension d'alimentation (GND), les troisième et quatrième broches d'alimentation (18, 19) l'une étant située d'une manière contiguë à l'autre, les première et deuxième broches d'alimentation étant situées à un côté du circuit intégré et les troisième et quatrième broches d'alimentation étant situées à un côté opposé du circuit intégré, des broches de sorties respectives des broches de sortie (17, 20) étant situées à côté de chacune des troisième et quatrième broches d'alimentation (18, 19).

3. Module de circuit intégré selon la revendication 1, dans lequel les broches de connexion externes sont agencées dans au moins une séquence de broches de connexion, les première et deuxième broches d'alimentation l'une étant située à côté de l'autre et d'une manière sensiblement centrale dans la séquence; la puce de circuit intégré (300) ayant une série de plages de contact (314, 316) qui se situent d'une manière contiguë à la séquence de broches de connexion, chaque broche de connexion respective des broches de connexion étant connectée à une plage de contact respective des plages de contact par l'intermédiaire d'un fil de liaison respectif des fils de liaison (322, 324); les plages de contact comprenant des première et deuxième plages d'alimentation qui sont connectées respectivement aux première et deuxième broches d'alimentation, les première et deuxième plages d'alimentation l'une étant située à côté de l'autre centralement dans la série; des première et deuxième plages de sortie étant situées respectivement à côté des première et deuxième plages d'alimentation, les première et deuxième plages de sortie étant connectées aux broches de sortie qui se situent respectivement à côté des première et deuxième broches d'alimentation.

4. Module de circuit intégré selon la revendication 3, les broches de connexion externes étant agencées dans au moins la séquence de broches de connexion et dans une nouvelle autre séquence de broches de connexion, la puce de circuit intégré étant située entre ladite séquence et ladite nouvelle autre séquence; les broches de connexion comportant des troisième et quatrième broches d'alimentation (18, 19) qui se situent l'une à côté de l'autre centralement dans ladite nouvelle autre séquence, les troisième et quatrième broches d'alimentation (18, 19) étant présentes pour être connectées respectivement aux première et deuxième tensions d'alimentation; la puce de circuit intégré (300) ayant une nouvelle autre série de plages de contact qui se situent d'une manière contiguë à la nouvelle autre séquence de broches de connexion, la nouvelle autre série de plages de contact comprenant des troisième et quatrième plages d'alimentation qui sont connectées respectivement aux troisième et quatrième broches d'alimentation, les troisième et quatrième plages d'alimentation l'une étant située à côté de l'autre dans la nouvelle autre série; des troisième et quatrième plages de sortie étant situées respectivement à côté des troisième et quatrième plages d'alimentation, les troisième et quatrième plages de sortie étant connectées à des broches de sortie qui se situent respectivement à côté des troisième et quatrième broches d'alimentation.

5. Module de circuit intégré selon la revendication 1, 2, 3 ou 4, dans lequel les broches de connexion comportent encore des broches de commande (10, 15, 22), telles qu'une entrée d'horloge, ou une validation de puce, ou une validation d'écriture, ou une validation de lecture, ou une validation de sortie, ou une validation de programme; les broches de connexion externes étant agencées dans au moins une séquence, la séquence comprenant les première et deuxième broches d'alimentation, au moins quelques-unes des broches de sortie et des broches de commande, pas de broche de commande n'étant située dans la séquence entre l'une quelconque des broches de sortie et des broches d'alimentation.

6. Module de circuit intégré selon la revendication 5, la séquence comprenant un noyau de broches de connexion comprenant toutes des broches de commande, des broches de sortie et des broches d'alimentation, la séquence comprenant des broches d'adressage, chacune étant située dans la séquence à l'extérieur dudit noyau.

7. Puce de circuit intégré comportant une matrice de mémoire ayant une série de plages de contact pour être connectées à des broches de connexion, où les plages de contact comprennent une première plage d'alimentation (316) pour recevoir une première tension d'alimentation (Vcc), une deuxième plage d'alimentation (314) pour recevoir une deuxième tension d'alimentation (GND) qui est différente de la première tension d'alimentation; les première et deuxième plages d'alimentation l'une étant située à côté de l'autre dans la série; **caractérisée en ce que** 1a série de plages de contact contient des plages de sortie, la puce de circuit intégré comportant des tampons de sortie qui sont couplés à des plages de sortie respectives des plages de sortie pour transmettre des signaux de sortie, une plage de sortie respective des plages de sortie étant située dans la série à côté de chacune des première et deuxième plages d'alimentation.

8. Puce de circuit intégré selon la revendication 7, comprenant une nouvelle autre série de plages de contacts, la série et la nouvelle autre série étant situées à des côtés opposés du substrat, la nouvelle autre série de plages de contact comprenant des troisième et quatrième plages d'alimentation qui se situent l'une à côté de l'autre pour recevoir respectivement les première et deuxième tensions d'alimentation, la série de plages de contact contenant de nouvelles autres plages de sortie, la puce de circuit intégré comportant de nouveaux autres tampons de sortie qui sont couplés à des plages de sortie respectives des nouvelles autres plages de sortie, des plages de sortie respectives des nouvelles autres plages de sortie étant situées dans la nouvelle autre série à côté de chacune des troisième et quatrième plages d'alimentation.

9. Puce de circuit intégré selon la revendication 7 ou 8, dans laquelle les plages de contact comprennent encore des plages de commande, telles qu'une entrée d'horloge, ou une validation de puce, ou une validation d'écriture, ou une validation de lecture, ou une validation de sortie, ou une validation de programme; les plages de commande étant situées dans la série de plages de commande, pas de plage de commande n'étant située dans la série entre l'une quelconque des plages de sortie et des plages d'alimentation.

10. Puce de circuit intégré selon la revendication 7, 8 ou 9, la série comprenant un noyau de plages de connexion comprenant toutes des plages de commande, des plages de sortie et des plages d'alimentation, la série comprenant des plages d'adressage, chacune étant située dans la série à l'extérieur dudit noyau.
